(19) **Europäisches Patentamt / European Patent Office / Office européen des brevets**

(11) **EP 1 783 889 B1**

(12) **FASCICULE DE BREVET EUROPEEN**

(45) Date de publication et mention
de la délivrance du brevet:
**02.09.2009   Bulletin 2009/36**

(51) Int Cl.:
***H02P 6/14*** *(2006.01)*      ***G01R 31/34*** *(2006.01)*

(21) Numéro de dépôt: **06123236.9**

(22) Date de dépôt: **31.10.2006**

(54) **Dispositif de surveillance du taux d'harmoniques dans l'alimentation d'une machine électrique synchrone à excitation par aimant permanent**

Vorrichtung zur Überwachung der Oberwellen bei der Versorgung einer elektrischen permanentmagneterregten Synchronmaschine

Device for monitoring the harmonics rate in the supply of a synchronous electric machine with permanent magnet excitation

(84) Etats contractants désignés:
**CH DE GB IT LI SE**

(30) Priorité: **03.11.2005   FR 0511189**

(43) Date de publication de la demande:
**09.05.2007   Bulletin 2007/19**

(73) Titulaire: **SOCIETE DE MECANIQUE MAGNETIQUE**
**F-27950 Saint-Marcel (FR)**

(72) Inventeurs:
• **Schroeder, Ulrich**
**76130 Mont Saint Aignan (FR)**
• **Brunet, Maurice**
**27950 Sainte Colombe près Vernon (FR)**
• **Kaffrey, Bertrand**
**76800 Saint Etienne du Rouvray (FR)**

(74) Mandataire: **Thévenet, Jean-Bruno et al**
**Cabinet Beau de Loménie**
**158, rue de l'Université**
**75340 Paris Cédex 07 (FR)**

(56) Documents cités:
**WO-A-99/29029**

• **CHING-YIN LEE ET AL: "Effects of Nonsinusoidal Voltage on the Operation Performance of a Three-phase Induction Motor" IEEE TRANSACTIONS ON ENERGY CONVERSION, IEEE SERVICE CENTER, PISCATAWAY, NJ, US, vol. 14, no. 2, juin 1999 (1999-06), pages 193-201, XP000913083 ISSN: 0885-8969**

# Description

La présente invention a pour objet un dispositif de surveillance du taux d'harmoniques dans l'alimentation d'une machine électrique synchrone à excitation par aimant permanent comportant un rotor sans cage d'amortissement, un stator avec des premier, deuxième et troisième bobinages, un convertisseur de fréquence et des circuits de contrôle du convertisseur de fréquence.

Les machines synchrones à excitation par aimants permanents et pilotées par un convertisseur de fréquence à vitesse variable, qui peuvent fonctionner en moteur ou en génératrice, présentent une très grande puissance volumique.

Ce type de machine ne génère que de très faibles pertes au rotor et se caractérise par une faible raideur négative. Ces machines électriques sont donc bien adaptées pour être utilisées en combinaison avec des paliers magnétiques.

De telles machines synchrones peuvent fonctionner à très haute vitesse.

Selon une technologie particulière, le rotor de la machine synchrone comprend des aimants permanents collés en surface sur un arbre massif en acier magnétique. Pour éviter un décollement dû aux forces centrifuges, on utilise une frette en fibres de carbone ou fibres de verre. Cette technique est compatible avec des vitesses linéaires pouvant aller jusqu'à environ 300 m/s.

Pour des puissances au-delà d'environ 50 kW, le stator de la machine est généralement refroidi par un liquide. De l'air ou un autre gaz de refroidissement peut également être introduit dans l'entrefer et assure alors une ventilation de cet entrefer, mais il existe également des cas où il est difficile de refroidir une telle machine.

Les machines synchrones à excitation par aimants permanents comportent un rotor sans cage d'amortissement. Un pilotage à vitesse variable par convertisseur de fréquence est donc nécessaire. Le convertisseur applique des courants variables en amplitude et en fréquence, aux bobinages du stator de la machine.

Comme indiqué plus haut, il est possible de travailler en mode moteur et en mode générateur. Un pilotage à vitesse variable en boucle ouverte - similaire au pilotage d'un moteur asynchrone - nécessite de plus une stabilisation électronique des oscillations angulaires pour éviter un risque de décrochage.

Pour améliorer la robustesse du système, il est préférable d'utiliser une information sur la position angulaire de la machine pour la synchronisation du convertisseur. Une synchronisation externe permet la re-synchronisation automatique de la machine en rotation après un décrochage.

Par principe, le convertisseur de fréquence génère des harmoniques dans les courants de phase de la machine. Ces harmoniques, ainsi que des courants continus, produisent des pertes supplémentaires au stator et au rotor. Les pertes au rotor, qui apparaissent sous la frette dans les aimants et dans l'arbre massif, sont particulièrement critiques dans ce type de machine. La frette en composite est un isolateur thermique qui empêche un refroidissement efficace du rotor. Une faible quantité de pertes peut rapidement conduire à des températures au-delà de la limite acceptable qui se situe à environ 150°C.

Pour remédier à ce problème, on a déjà proposé d'utiliser des filtres de puissance pour réduire le taux d'harmoniques en dessous de la valeur acceptable. Pour une machine ayant une puissance supérieure à 50 kW, l'ordre de grandeur d'un seuil maximum acceptable correspond à un taux de distorsion harmonique totale d'environ 5 à 10%.

Même en cas d'utilisation de filtres de puissance, il peut apparaître dans la pratique que le taux d'harmonique augmente au-delà de la valeur maximale acceptable, par exemple à cause d'une instabilité des circuits électroniques de contrôle du convertisseur de fréquence, ou encore à cause d'une défaillance dans le filtre de puissance ou dans la connectique.

Dans ce cas, la température du rotor augmente très vite, ce qui risque de conduire à la destruction de la frette de maintien des aimants permanents, puis à une destruction de l'ensemble de la machine.

Les solutions classiques, par exemple de surveillance de la température du stator, ne permettent pas d'éviter des échauffements localisés notamment au niveau des frettes.

La présente invention a pour but de remédier aux inconvénients précités et de permettre d'assurer l'arrêt d'urgence d'une machine, en cas d'échauffement provoqué par des pertes au niveau du rotor, avant que la machine soit endommagée ou détruite.

Le document de Ching-Ying Lee et Al ("Effects of nonsinusoidal voltage on the operation performance of a three-phase induction motor', IEEE, Piscataway, 02/06/1999) décrit les performances d'un moteur triphasé à induction.

L'invention a encore pour but de fournir une solution simple et économique, qui soit fiable et n'implique pas la mise en oeuvre de composants fragiles ou coûteux ou une modification de fonctionnement du convertisseur associé à la machine synchrone.

Ces buts sont atteints grâce à un dispositif de surveillance du taux d'harmoniques dans l'alimentation d'une machine électrique synchrone à excitation par aimant permanent comportant un rotor sans cage d'amortissement, un stator avec des premier, deuxième et troisième bobinages, un convertisseur de fréquence et des circuits de contrôle du convertisseur de fréquence, caractérisé en ce qu'il comprend des moyens de prélèvement d'au moins une information de courant dans le premier bobinage du stator et d'au moins une information de courant dans le deuxième bobinage du stator ; un circuit de génération d'impulsions de synchronisation reflétant la fréquence électrique de rotation du rotor par rapport au stator ; des moyens de détermination de l'information de courant dans le troisième bobinage du stator ; un ensemble de filtres sélectifs coupe-bande recevant respectivement lesdites informations de courant dans les premier, deuxième et troisième bobinages, et présentant chacun une fréquence centrale asservie à la fréquence électrique de rotation du rotor, afin de retirer l'harmonique correspondant à cette fréquence électrique ; un ensemble de circuits de mesure des harmoniques restant dans les signaux fournis en sortie de chacun des filtres sélectifs coupe-bande ; et un circuit comparateur pour comparer en permanence la plus grande des valeurs des signaux issus des circuits de mesure par rapport à un seuil d'alarme.

Les filtres sélectifs coupe-bande peuvent être du type à capacité commutée.

Avantageusement, les filtres sélectifs coupe-bande présentent une fréquence d'horloge qui est égale à un nombre entier n de fois la valeur de la fréquence électrique de rotation du rotor.

Selon un mode particulier de réalisation, le dispositif comprend un circuit multiplicateur de fréquence à boucle à verrouillage de phase pour produire ladite fréquence d'horloge à partir de la fréquence électrique de rotation du rotor fournie par ledit circuit de génération d'impulsions de synchronisation.

De préférence, les moyens de détermination de l'information de courant dans le troisième bobinage du stator comprennent un circuit analogique de calcul de la valeur du courant dans le troisième bobinage à partir des valeurs mesurées des courants dans les premier et deuxième bobinages.

Selon un mode particulier de réalisation, les circuits de mesure des harmoniques restants comprennent chacun un dispositif de mesure du type multimètre quadratique.

Le dispositif de surveillance selon l'invention peut en outre comprendre des éléments de filtrage interposés entre les circuits de mesure des harmoniques restant et le circuit comparateur.

Selon un mode particulier de réalisation, le circuit de génération d'impulsions de synchronisation comprend un capteur de vitesse de rotation du rotor du type "top tour".

Selon un autre mode de réalisation possible, le dispositif de surveillance comprend des moyens de prélèvement d'informations de tension pour chaque phase en sortie du convertisseur et lesdites informations de tensions prélevées et ladite information de courant dans le premier bobinage du stator sont appliquées au circuit de génération d'impulsions de synchronisation.

L'invention concerne également un dispositif de pilotage d'une machine électrique synchrone à excitation par aimant permanent comportant un rotor sans cage d'amortissement et un stator avec des premier, deuxième et troisième bobinages, lequel dispositif de pilotage comprend un convertisseur de fréquence et des circuits de contrôle du convertisseur de fréquence, le dispositif de pilotage étant caractérisé en ce qu'il comprend un dispositif de surveillance du taux d'harmoniques dans l'alimentation de la machine électrique synchrone, comme défini ci-dessus et en ce que le circuit de génération d'impulsions de synchronisation reflétant la fréquence électrique (fn) de rotation du rotor est incorporé dans lesdits circuits de contrôle du convertisseur de fréquence.

L'invention a encore pour objet un dispositif d'entraînement d'un ensemble tournant monté sur des paliers magnétiques actifs, caractérisé en ce qu'il comprend une machine électrique synchrone équipée d'un dispositif de pilotage tel que défini ci-dessus.

L'invention s'applique en particulier à un dispositif d'entraînement dans lequel le rotor de la machine synchrone comprend un arbre massif en acier magnétique sur lequel sont collés en surface des aimants permanents qui sont en outre maintenus par au moins une frette en fibres de carbone ou fibres de verre.

L'invention s'applique en outre avantageusement à un dispositif d'entraînement comprenant un moteur synchrone d'entraînement d'une pompe turbomoléculaire, d'une turbomachine ou d'une broche porte-outil tournant à des vitesses de l'ordre de plusieurs dizaines de milliers de tours par minute.

D'autres caractéristiques et avantages de l'invention ressortiront de la description suivante de modes particuliers de réalisation donnés à titre d'exemples, en référence aux dessins annexés, sur lesquels :

- la Figure 1 est une vue schématique d'ensemble des principaux composants d'un moteur synchrone à excitation à aimant permanent auquel est appliqué le dispositif de surveillance selon l'invention;
- la Figure 2 est un schéma-bloc d'un exemple de dispositif de surveillance de taux d'harmoniques, conforme à l'invention ; et
- la Figure 3 est une vue en coupe d'un exemple de rotor de moteur synchrone auquel est applicable l'invention.

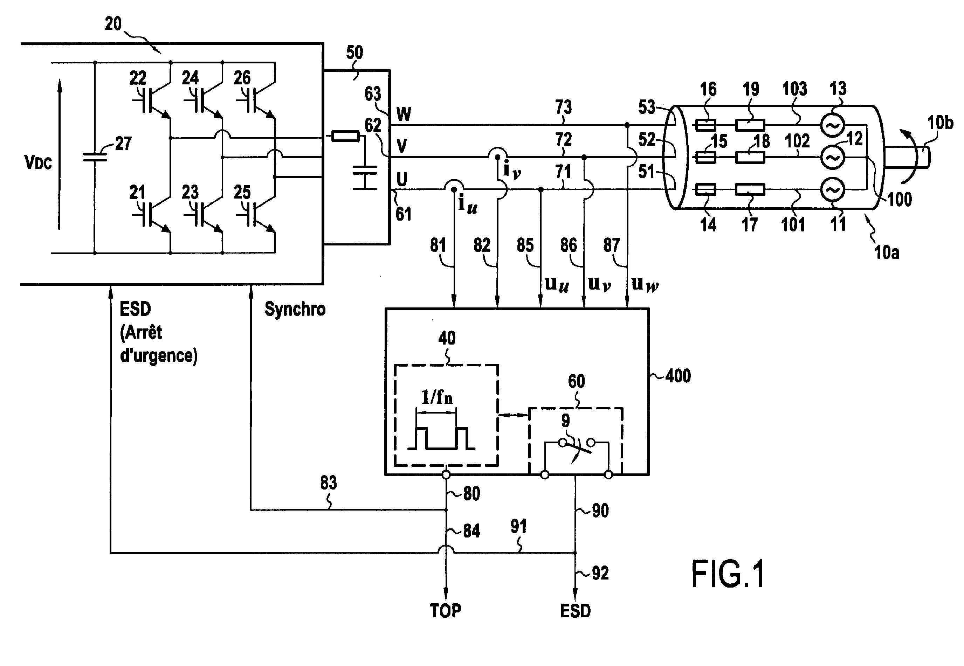

La Figure 1 montre un exemple de machine synchrone à aimants permanents à laquelle est applicable l'invention.

On voit sur la Figure 1 la représentation symbolique du stator 10a d'un moteur synchrone à excitation par aimant permanent, avec des bobinages 101, 102, 103 correspondant à des phases U V W qui sont connectées entre un point commun 100 et des bornes 51, 52, 53.

En fonctionnement, chaque bobinage 101, 102, 103 de chaque phase U V W peut être représenté par une force électromotrice 11, 12, 13 correspondant à la tension induite à vide, une résistance 14, 15, 16 et une inductance 17, 18, 19.

Les bornes 51, 52, 53 du stator 10 sont reliées par des liaisons 71, 72, 73 à des bornes 61, 62, 63 de sortie d'un convertisseur de fréquence 20 ou onduleur. Un filtre de puissance 50 est toutefois avantageusement disposé à la sortie du convertisseur de fréquence 20 et les bornes 61, 62, 63 peuvent alors être placées en sortie du filtre 50.

Le convertisseur de fréquence 20 est associé à un circuit 40 de contrôle du convertisseur. L'étage de puissance du convertisseur 20 comprend un pont de six interrupteurs électroniques 21 à 26 alimentés par une source qui peut être associée à un condensateur 27 de tension continue $V_{DC}$. Les interrupteurs 21 à 26 sont commandés depuis le circuit 40 de contrôle à travers des fils de commande 80, 83. La commande des interrupteurs est effectuée en tout ou rien à fréquence élevée, de l'ordre de 5 à 50 kHz, en utilisant la technique de modulation en largeur d'impulsion PWM ("pulse width modulation"). Il apparaît ainsi aux bornes du stator 10a du moteur des "blocs" de tension avec une amplitude égale à $+V_{DC}$ ou $-V_{DC}$.

Les courants statoriques $i_u$, $i_v$, $i_w$ peuvent faire l'objet d'une modulation sinusoïdale ou d'une modulation rectangulaire. La modulation sinusoïdale est plus compliquée au niveau du traitement du signal, mais contribue à améliorer les performances du moteur dans la mesure où l'échauffement rotorique est plus faible et la rotation de meilleure qualité. La modulation rectangulaire est plus simple à mettre en oeuvre et est notamment utilisée pour les moteurs de faible puissance (moteurs de type sans balai ou "brushless").

Le dispositif 40 de commande du convertisseur de fréquence 20 comprend essentiellement un circuit de calcul qui reçoit, par des lignes 85, 86, 87, des informations de tension toujours disponibles sur les bornes 61, 62, 63 de sortie du convertisseur 20 ou sur les bornes d'entrée 51, 52, 53 du stator 10a du moteur.

De même, des informations $i_u$, $i_v$ concernant les courants dans les bobinages 101, 102 sont prélevées dans le convertisseur 20 par des lignes 81, 82 et sont appliquées également au circuit 40 de contrôle du convertisseur.

Le circuit de contrôle 40 permet l'émission sur des lignes 80, 83, 84 de signaux impulsionnels de synchronisation, ces signaux impulsionnels de synchronisation comportant des fronts positifs indiquant la position angulaire du rotor 10b par rapport au stator 10a.

Le circuit de commande 40 permet également de fournir sur la ligne 84 un signal de vitesse fournissant une impulsion par tour pour commander un système de commande automatique de balourd associé à des paliers magnétiques actifs de support d'un ensemble tournant entraîné par le moteur synchrone.

D'une manière avantageuse, le circuit 40 de commande du convertisseur de fréquence 20, qui peut aussi incorporer un système de commande automatique de balourd, peut être réalisé de la façon indiquée dans le document de brevet WO 98/11662. Un tel mode de réalisation permet notamment d'éviter l'utilisation de capteurs de position angulaire et se combine parfaitement avec le dispositif de surveillance selon la présente invention, qui va maintenant être décrit ci-dessous. En particulier, les signaux impulsionnels de synchronisation engendrés dans le circuit de commande 40 peuvent être utilisés à la fois pour la synchronisation du convertisseur de fréquence 20 et pour la détection des harmoniques non synchrones comme cela sera exposé plus loin.

La présente invention est toutefois compatible avec d'autres modes de réalisation de circuits de commande du convertisseur de fréquence 20. Dans ce cas, il est seulement nécessaire de disposer d'un dispositif de génération de signaux impulsionnels de synchronisation pour engendrer un signal représentant l'harmonique de rotation (ou fréquence électrique) fn du rotor 10b du moteur synchrone, cet harmonique de rotation représentant la partie utile du courant produisant le couple au sein du moteur. Si l'on dispose par exemple d'un capteur de vitesse de rotation du type "top tour", les signaux issus de ce capteur peuvent être utilisés directement pour assurer la synchronisation du dispositif de surveillance et il n'est plus nécessaire d'appliquer au circuit de commande 40 des informations de tension prélevées pour chaque phase en sortie du convertisseur.

D'une façon générale, l'harmonique de rotation ou fréquence électrique fn est donné par la relation suivante :

$$fn = p * f_{mech}$$

où $f_{mech}$ = fréquence mécanique
p = nombre de paires de pôles du moteur.

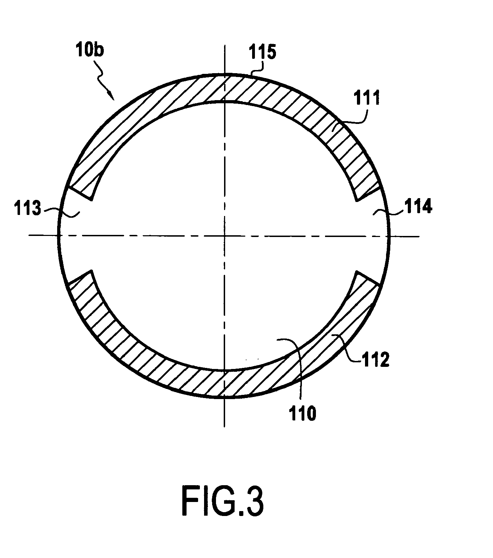

On a représenté sur la Figure 3 un exemple de réalisation d'un rotor 10b équipé d'aimants permanents 111, 112.

Le rotor 10b peut ainsi être constitué par un arbre massif en acier magnétique 110 sur lequel sont collés en surface des aimants permanents 111, 112, par exemple en samarium cobalt, placés dans des encoches délimitées par des portions 113, 114 de l'arbre massif 110. Une ou plusieurs frettes 115 en fibre de carbone ou fibre de verre assurent un maintien en position des aimants permanents 111, 112 et évitent un décollement de ceux-ci, notamment dans le cas de vitesses de rotation très élevées, qui peuvent être de l'ordre de plusieurs dizaines de milliers de tours par minute, avec des vitesses linéaires pouvant aller jusqu'à 300 m/s.

Comme on l'a déjà indiqué plus haut, la frette 115 en matériau composite est un isolateur thermique qui empêche un refroidissement efficace du rotor 10b et une faible quantité de pertes du rotor, provoquées par la présence d'harmoniques dans les courants de phase du moteur, peut conduire à des températures qui dépassent la limite acceptable de par exemple 150°C.

Le dispositif 60 selon l'invention, qui peut être associé aux circuits 40 de commande du convertisseur dans un dispositif 400 de pilotage d'une machine synchrone à excitation par aimants permanents, permet de surveiller en temps réel le taux d'harmoniques dans les phases de la machine, et de provoquer un arrêt d'urgence de la machine, par action sur des lignes de commande 90, 91, 92 associées à un contact de relais 9, lorsque le taux d'harmoniques dépasse un seuil prédéterminé.

Diverses solutions numériques ou analogiques existent pour mesurer et analyser les harmoniques de courant dans les phases d'une machine électrique. Ces diverses méthodes sont cependant relativement coûteuses et difficiles à mettre en oeuvre sur une machine en service.

Le dispositif de surveillance 60 selon la présente invention est indépendant de la fonction du convertisseur 20 et particulièrement simple, bon marché et fiable, dès lors qu'il implique seulement la production d'un signal comprenant une impulsion qui peut à la fois servir à la détection des harmoniques et en option permettre la synchronisation du convertisseur 20 ainsi que, le cas échéant, la synchronisation d'un système de réjection des vibrations synchrones dues au balourd du rotor.

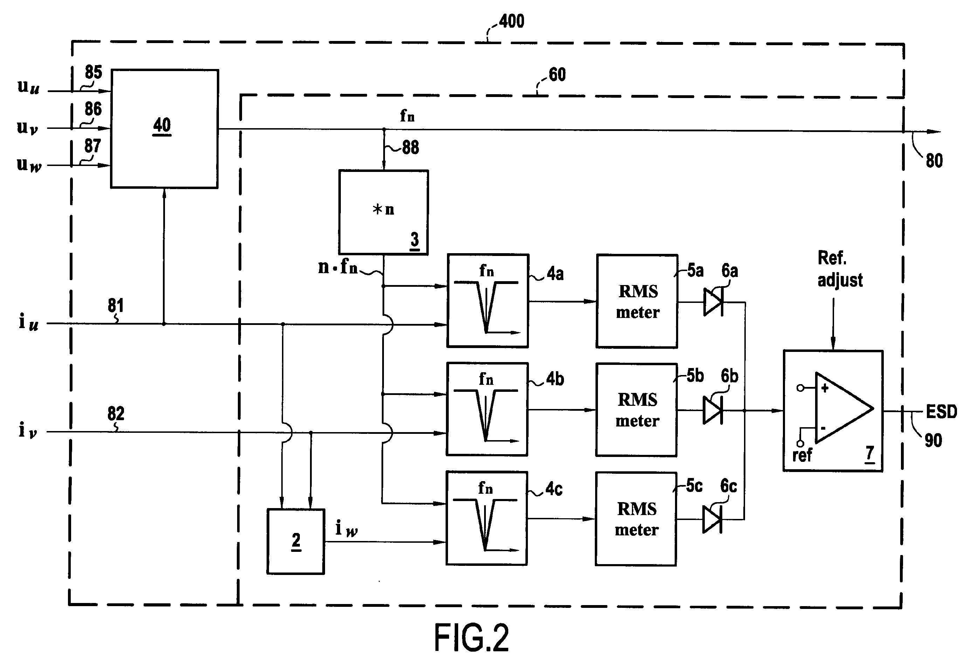

Comme on l'a déjà vu en référence à la Figure 1, et comme cela est également visible sur la Figure 2, le dispositif selon l'invention utilise en entrée des informations disponibles à la sortie du convertisseur de fréquence 20, à savoir deux informations de courant $i_u$, $i_v$ et les informations de tension $u_u$, $u_v$, $u_w$.

Le dispositif de surveillance selon l'invention inclut une fonction de rejet de l'harmonique de rotation fn, qui est la partie utile du courant produisant le couple, et une fonction consistant à analyser ensuite les harmoniques non synchrones restant, qui constituent la partie inutile du courant qui génère des pertes. L'arrêt d'urgence de la machine est déclenché si ces harmoniques non synchrones dépassent un certain seuil critique conduisant à un échauffement critique.

Un exemple de réalisation du dispositif de surveillance 60 selon l'invention est illustré sur la Figure 2.

Comme on l'a vu en référence à la Figure 1, le dispositif de commande 40 qui reçoit les informations de tensions $u_u$, $u_v$, $u_w$ et au moins une information de courant $i_u$, permet de générer un signal impulsionnel, qui représente l'harmonique de rotation (fréquence électrique) fn du rotor 10b, sur une ligne 80 pouvant être reliée au convertisseur 20, et sur une ligne 88 de liaison à un multiplicateur de fréquence 3.

Le dispositif de surveillance 60 reçoit par ailleurs sur des lignes 81, 82 les informations du courant $i_u$ et $i_v$ mesuré dans les deux phases U et V par des capteurs de courant.

Le courant dans la phase W pourrait également être mesuré à l'aide d'un capteur de courant. Toutefois, et de façon plus simple, le courant $i_w$ dans la troisième phase W est calculé dans un simple circuit analogique 2 à partir des informations de courant $i_u$ et $i_v$ fournies sur les lignes 81 et 82, selon la relation suivante : $i_u + i_v + i_w = 0$.

Les informations de courant $i_u$, $i_v$, $i_w$ des trois phases sont appliquées chacune à un filtre sélectif d'ordre élevé 4a, 4b, 4c respectivement afin de retirer l'harmonique de rotation fn.

A titre d'exemple, les filtres sélectifs coupe-bande 4a, 4b, 4c de réjection de l'harmonique de rotation fn sont du type à capacité commutée.

Les filtres coupe-bande 4a, 4b, 4c reçoivent un signal d'horloge n.fn qui est égal à un nombre entier n de fois la valeur de la fréquence électrique fn de rotation du rotor 10b, et présentent chacun une fréquence centrale de réjection asservie à la fréquence électrique fn de rotation du rotor 10b.

La fréquence d'horloge n.fn peut être produite par un circuit multiplicateur de fréquence 3 à boucle de verrouillage de phase, à partir de la fréquence électrique fn de rotation du rotor 10b fournie par le circuit 40 de génération d'impulsions de synchronisation.

Les signaux issus des filtres coupe-bande 4a, 4b, 4c sont appliqués à des circuits 5a, 5b, 5c de mesure des harmoniques restant dans ces signaux, y compris la valeur de la composante continue qui contribue également à l'échauffement.

Les circuits 5a, 5b, 5c peuvent être réalisés à partir de circuits intégrés tels que ceux utilisés dans des multimètres quadratiques, du type "true RMS meter".

De tels multimètres quadratiques permettent de prendre en compte la valeur efficace d'une grandeur périodique complexe. De la sorte en l'espèce, des circuits de ce type permettent de prendre en compte l'ensemble des composantes de signal contribuant à un échauffement, c'est-à-dire à la fois les composantes alternatives des harmoniques jusqu'à des valeurs au-delà de plusieurs dizaines de kilohertz et la composante continue.

Les signaux de sortie des circuits 5a, 5b, 5c sont appliqués, sous la forme de signaux de courant continus, par exemple à l'aide de diodes 6a, 6b, 6c, à un circuit comparateur 7 qui compare en permanence la plus grande des trois valeurs à un seuil d'alarme prédéterminé Ref.

Le signal de sortie du comparateur 7 permet d'ouvrir un contact de relais 9 qui est normalement fermé (représenté symboliquement sur la Figure 1), en cas de dépassement du seuil Ref par l'un des signaux appliqués en entrée du comparateur 7.

Lorsque ce contact 9 est ouvert, il est produit sur des lignes 90, 91, 92 un signal qui permet de commander l'arrêt d'urgence de la machine synchrone, en agissant notamment sur le convertisseur 20, de manière à préserver l'intégrité de cette machine.

L'invention est particulièrement utile lorsqu'elle est appliquée à la surveillance du moteur électrique d'entraînement d'une pompe turbomoléculaire, d'une turbomachine, telle qu'un compresseur, ou d'une broche porte-outil tournant à des vitesses de l'ordre de plusieurs dizaines de milliers de tours par minute.

## Revendications

**1.** Dispositif de surveillance du taux d'harmoniques dans l'alimentation d'une machine électrique synchrone à excitation par aimant permanent comportant un rotor (10b) sans cage d'amortissement, un stator (10a) avec des premier, deuxième et troisième bobinages (101, 102, 103), un convertisseur de fréquence (20) et des circuits (40) de contrôle du convertisseur de fréquence,
des moyens (81, 82) de prélèvement d'au moins une information de courant ($i_u$) dans le premier bobinage (101) du stator (10a) et d'au moins une information de courant ($i_v$) dans le deuxième bobinage (102) du stator (10a) des moyens de détermination de l'information de courant ($i_w$) dans le troisième bobinage (103) du stator (10a); **caractérisé en ce qu'**il comprend un circuit (40) de génération d'impulsions de synchronisation reflétant la fréquence électrique (fn) de rotation du rotor (10b) par rapport au stator (10a), un ensemble de filtres sélectifs coupe-bande (4a, 4b, 4c) recevant respectivement lesdites informations de courant ($i_u$, $i_v$, $i_w$) dans les premier, deuxième et troisième bobinages (101, 102, 103), et présentant chacun une fréquence centrale asservie à la fréquence électrique (fn) de rotation du rotor (10b), afin de retirer l'harmonique correspondant à cette fréquence électrique (fn) ; un ensemble de circuits (5a, 5b, 5c) de mesure des harmoniques restant dans les signaux fournis en sortie de chacun des filtres sélectifs coupe-bande (4a, 4b, 4c) ; et un circuit comparateur (7) pour comparer en permanence la plus grande des valeurs des signaux issus des circuits de mesure (5a, 5b, 5c) par rapport à un seuil d'alarme (Ref).

**2.** Dispositif selon la revendication 1, **caractérisé en ce que** les filtres sélectifs coupe-bande (4a, 4b, 4c) sont du type à capacité commutée.

**3.** Dispositif selon la revendication 1 ou la revendication 2,
**caractérisé en ce que** les filtres sélectifs coupe-bande (4a, 4b, 4c) présentent une fréquence d'horloge (n.fn) qui est égale à un nombre entier n de fois la valeur de la fréquence électrique (fn) de rotation du rotor (10b).

**4.** Dispositif selon la revendication 3, **caractérisé en ce qu'**il comprend un circuit multiplicateur de fréquence (3) à boucle à verrouillage de phase pour produire ladite fréquence d'horloge (n.fn) à partir de la fréquence électrique (fn) de rotation du rotor (10b) fournie par ledit circuit (40) de génération d'impulsions de synchronisation.

**5.** Dispositif selon l'une quelconque des revendications 1 à 4,
**caractérisé en ce que** lesdits moyens de détermination de l'information de courant ($i_w$) dans le troisième bobinage (103) du stator (10a) comprennent un circuit analogique (2) de calcul de la valeur du courant ($i_w$) dans le troisième bobinage (103) à partir des valeurs mesurées des courants ($i_u$, $i_v$) dans les premier et deuxième bobinages (101, 102).

**6.** Dispositif selon l'une quelconque des revendications 1 à 5,
**caractérisé en ce que** lesdits circuits (5a, 5b, 5c) de mesure des harmoniques restants comprennent chacun un dispositif de mesure du type multimètre quadratique.

**7.** Dispositif selon l'une quelconque des revendications 1 à 6,
**caractérisé en ce qu'**il comprend en outre des éléments de filtrage (6a, 6b, 6c) interposés entre les circuits (5a, 5b, 5c) de mesure des harmoniques restants et le circuit comparateur (7).

**8.** Dispositif selon l'une quelconque des revendications 1 à 7,
**caractérisé en ce que** le circuit (40) de génération d'impulsions de synchronisation comprend un capteur de vitesse de rotation du rotor de type "top tour".

**9.** Dispositif selon l'une quelconque des revendications 1 à 7,
**caractérisé en ce qu'**il comprend des moyens (85, 86, 87) de prélèvement d'informations de tension ($u_u$, $u_v$, $u_w$) pour chaque phase en sortie du convertisseur (20) et **en ce que** lesdites informations de tension ($u_u$, $u_v$, $u_w$) prélevées et ladite information de courant ($i_u$) dans le premier bobinage (101) du stator (104) sont appliquées au circuit (40) de génération d'impulsions de synchronisation.

**10.** Dispositif de pilotage d'une machine électrique synchrone à excitation par aimant permanent comportant un rotor (10b) sans cage d'amortissement et un stator (10a) avec des premier, deuxième et troisième bobinages (101, 102, 103), lequel dispositif de pilotage comprend un convertisseur de fréquence (20) et des circuits (40) de contrôle du convertisseur de fréquence, **caractérisé en ce qu'**il comprend un dispositif de surveillance du taux d'harmoniques dans l'alimentation de la machine synchrone, selon l'une quelconque des revendications 1 à 9, et **en ce que** le circuit de génération d'impulsions de synchronisation reflétant la fréquence électrique (fn) de rotation du rotor (10b) est incorporé dans lesdits circuits (40) de contrôle du convertisseur de fréquence.

**11.** Dispositif d'entraînement d'un ensemble tournant monté sur des paliers magnétiques actifs, **caractérisé en ce qu'**il comprend une machine électrique synchrone équipée d'un dispositif de pilotage selon la revendication 10.

**12.** Dispositif d'entraînement selon la revendication 11, **caractérisé en ce que** le rotor (10b) de la machine synchrone comprend un arbre massif (110) en acier magnétique sur lequel sont collés en surface des aimants permanents (111, 112) qui sont en outre maintenus par au moins une frette (115) en fibres de carbone ou fibres de verre.

13. Dispositif d'entraînement selon la revendication 11 ou la revendication 12, **caractérisé en ce qu'**il comprend un moteur synchrone d'entraînement d'une pompe turbomoléculaire, d'une turbomachine ou d'une broche porte-outil tournant à des vitesses de l'ordre de plusieurs dizaines de milliers de tours par minute.

## Claims

1. A device for monitoring harmonic distortion in the power supply of a synchronous electrical machine with permanent magnet excitation that comprises a rotor (10b) without a damper cage, a stator (10a) with first, second, and third windings (101, 102, 103), a frequency converter (20), and control circuits (40) for controlling the frequency converter, means (81, 82) for obtaining at least one signal representative of the current ($i_u$) in the first winding (101) of the stator (10a) and at least one signal representative of the current ($i_v$) in the second winding (102) of the stator (10a) ; means for determining a signal representative of the current ($i_w$) in the third winding (103) of the stator (10a), **characterized in that** it comprises a circuit (40) for generating synchronizing pulses reflecting the electrical frequency (fn) of rotation of the rotor (10b) relative to the stator (10a) ; a set of band-stop notch filters (4a, 4b, 4c) respectively receiving said signals representative of the currents ($i_u$, $i_v$, $i_w$) in the first, second, and third windings (101, 102, 103), and each presenting a center frequency that is servo-controlled to the electrical frequency (fn) of rotation of the rotor (10b), in order to reject the harmonic corresponding to said electrical frequency (fn); a set of measurement circuits (5a, 5b, 5c) for measuring the harmonics that remain in the signals output by each of the band-stop notch filters (4a, 4b, 4c); and a comparator circuit (7) for continuously comparing the greatest of the values of the signals from the measurement circuits (5a, 5b, 5c) relative to an alarm threshold (Ref).

2. A device according to claim 1, **characterized in that** the band-stop notch filters (4a, 4b, 4c) are of the switched capacitor type.

3. A device according to claim 1 or claim 2, **characterized in that** the band-stop notch filters (4a, 4b, 4c) present a clock frequency (n.fn) that is equal to an integer number n of times the value of the electrical frequency (fn) of rotation of the rotor

(IOb).

4. A device according to claim 3, **characterized in that** it includes a frequency multiplier circuit (3) with a phase-locked loop for producing said clock frequency (n.fn) from the electrical frequency (fn) of rotation of the rotor (10b) delivered by said circuit (40) for generating synchronizing pulses.

5. A device according to any one of claims 1 to 4, **characterized in that** said means for determining the signal representative of the current ($i_w$) in the third winding (103) of the stator (10a) comprise an analog circuit (2) for calculating the value of the current ($i_w$) in the third winding (103) from the measured values of the current ($i_u$, $i_v$) in the second and third windings (101, 102).

6. A device according to any one of claims 1 to 5, **characterized in that** each of said measurement circuits (5a, 5b, 5c) for measuring the remaining harmonics comprises a measurement circuit of the RMS multimeter type.

7. A device according to any one of claims 1 to 6, **characterized in that** it further comprises filter elements (6a, 6b, 6c) interposed between the measurement circuits (5a, 5b, 5c) for measuring the remaining harmonics and the comparator circuit (7).

8. A device according to any one of claims 1 to 7, **characterized in that** the circuit (40) for generating synchronizing pulses comprises a "revolution pulse" type sensor for sensing the speed of rotation of the rotor.

9. A device according to any one of claims 1 to 7, **characterized in that** it includes means (85, 86, 87) for taking signals representative of voltage ($u_u$, $u_v$, $u_w$) for each phase outlet by the converter (20), and **in that** said signals representative of the voltages ($u_u$, $u_v$, $u_w$) and said signal representative of the current ($i_u$) in the first winding (101) of the stator (104) are applied to the circuit (40) for generating synchronizing pulses.

10. A device for controlling a synchronous electrical machine with permanent magnet excitation that comprises a rotor (10b) without a damper cage and a stator (10a) with first, second, and third windings (101, 102, 103), which control unit comprises a frequency converter (20) and control circuits (40) for controlling the frequency converter, the unit being **characterized in that** it includes a device for monitoring harmonic distortion in the power supply to the synchronous machine according to any one of claims 1 to 9, and **in that** the circuit for generating synchronizing pulses representative of the electrical frequency (fn) of rotation of the rotor (10b) is incorporated in said control circuits (40) for controlling the frequency converter.

11. A driver device for driving a rotary assembly mounted on active magnetic bearings, the driver device being **characterized in that** it comprises a synchronous electrical machine fitted with a control device according to claim 10.

12. A driver device according to claim 11, **characterized in that** the rotor (10b) of the synchronous machine comprises a massive shaft (110) of magnetic steel having permanent magnets (111, 112) bonded to its surface, which magnets are also held by means of at least one binding band (115) of carbon fibers or glass fibers.

13. A driver device according to claim 11 or claim 12, **characterized in that** it comprises a synchronous machine for driving a turbomolecular pump, a turbomachine, or a tool-carrier spindle rotating at speeds of the order of several tens of thousands of revolutions per minute.

## Patentansprüche

1. Vorrichtung zur Überwachung des Oberschwingungsgehaltes bei der Versorgung einer permanentmagneterregten elektrischen Synchronmaschine umfassend einen Rotor (10b) ohne Dämpfungskäfig, einen Stator (10a) mit einer ersten, einer zweiten und einer dritten Spule (101, 102, 103), einen Frequenzwandler (20) und Kreise (40) zur Kontrolle des Frequenzwandlers, Mittel (81, 82) zur Entnahme wenigstens einer Strominformation ($i_u$) aus der ersten Spule (101) des Stators (10a) sowie wenigstens einer Strominformation ($i_v$) aus der zweiten Spule (102) des Stators (10a), Mittel zur Bestimmung der Strominformation ($i_w$) in der dritten Spule (103) des Stators (10a), **dadurch gekennzeichnet, daß** sie folgendes umfaßt, nämlich einen Kreis (40) zur Erzeugung von Synchronisierungsimpulsen, welche die elektrische Rotationsfrequenz (fn) des Rotors (10b) gegenüber dem Stator (10a) wiederspiegeln, eine Anordnung von selektiven Bandsperrfiltern (4a, 4b, 4c), welche die Strominformationen ($i_u$, $i_v$ bzw. $i_w$) aus der ersten, der zweiten und der dritten Spule (101, 102, 103) empfangen und jeweils eine von der elektrischen Rotationsfrequenz (fn) des Rotors (10b) abhängige Mittenfrequenz aufweisen, um die dieser elektrischen Frequenz (fn) entsprechende Oberschwingung herauszunehmen, eine Anordnung von Kreisen (5a, 5b, 5c) zur Messung der Oberschwingungen, die in den am Ausgang eines jeden der selektiven Bandsperrfilter (4a, 4b, 4c) gelieferten Signalen verbleiben, sowie einen Vergleichskreis (7), um den größten der Werte der Signale aus den Meßkreisen (5a, 5b, 5c) ständig mit einer Alarmschwelle (Ref) zu vergleichen.

2. Vorrichtung nach Anspruch 1, **dadurch gekennzeichnet, daß** die selektiven Bandsperrfilter (4a, 4b, 4c) vom Typ mit geschalteter Kapazität sind.

3. Vorrichtung nach Anspruch 1 oder Anspruch 2, **dadurch gekennzeichnet, daß** die selektiven Bandsperrfilter (4a, 4b, 4c) eine Taktfrequenz (n.fn) aufweisen, die gleich einem ganzzahligen Vielfachen n des Wertes der elektrischen Rotationsfrequenz (fn) des Rotors (10b) ist.

4. Vorrichtung nach Anspruch 3, **dadurch gekennzeichnet, daß** sie einen Frequenzvervielfachungskreis (3) mit Phasenverriegelungsschleife umfaßt, um die Taktfrequenz (n.fn) anhand der durch den Kreis (40) zur Erzeugung von Synchronisierungsimpulsen gelieferten elektrischen Rotationsfrequenz (fn) des Rotors (10b) zu erzeugen.

5. Vorrichtung nach einem der Ansprüche 1 bis 4, **dadurch gekennzeichnet, daß** die Mittel zur Bestimmung der Strominformation ($i_w$) in der dritten Spule (103) des Stators (10a) einen Analogkreis (2) zur Berechnung des Wertes des Stroms ($i_w$) in der dritten Spule (103) anhand der gemessenen Werte der Ströme ($i_u$, $i_v$) in der ersten und der zweiten Spule (101, 102) umfassen.

6. Vorrichtung nach einem der Ansprüche 1 bis 5, **dadurch gekennzeichnet, daß** die Kreise (5a, 5b, 5c) zur Messung der verbleibenden Oberschwingungen jeweils eine Meßvorrichtung von der Art Effektivwert-Multimeter umfassen.

7. Vorrichtung nach einem der Ansprüche 1 bis 6, **dadurch gekennzeichnet, daß** sie ferner Filterelemente (6a, 6b, 6c) umfaßt, die zwischen den Kreisen (5a, 5b, 5c) zur Messung der verbleibenden Oberschwingungen und dem Vergleichskreis (7) zwischengeschaltet sind.

8. Vorrichtung nach einem der Ansprüche 1 bis 7, **dadurch gekennzeichnet, daß** der Kreis (40) zur Erzeugung von Synchronisierungsimpulsen einen Rotordrehzahlsensor vom Typ "Phasenindikator" umfaßt.

9. Vorrichtung nach einem der Ansprüche 1 bis 7, **dadurch gekennzeichnet, daß** sie Mittel (85, 86, 87) zur Entnahme von Spannungsinformationen ($u_u$, $u_v$, $u_w$) für jede Phase am Ausgang des Wandlers (20) umfaßt, und daß die entnommenen Spannungsinformationen ($u_u$, $u_v$, $u_w$) und die Strominformation ($i_u$) aus der ersten Spule (101) des Stators (10a) an den Kreis (40) zur Erzeugung von Synchronisierungsimpulsen angelegt werden.

10. Vorrichtung zur Steuerung einer permanentmagneterregten elektrischen Synchronmaschine umfassend einen Rotor (10b) ohne Dämpfungskäfig und einen Stator (10a) mit einer ersten, einer zweiten und einer dritten Spule (101, 102, 103), wobei die Steuerungsvorrichtung einen Frequenzwandler (20) und Kreise (40) zur Kontrolle des Frequenzwandlers umfaßt, **dadurch gekennzeichnet, daß** sie eine Vorrichtung zur Überwachung des Oberschwingungsgehaltes bei der Versorgung der Synchronmaschine nach einem der Ansprüche 1 bis 9 umfaßt, und daß der Kreis zur Erzeugung von Synchronisierungsimpulsen, welche die elektrische Rotationsfrequenz (fn) des Rotors (10b) wiederspiegeln, in die Kreise (40) zur Kontrolle des Frequenzwandlers integriert ist.

11. Vorrichtung für den Antrieb einer in aktiven Magnetlagern angebrachten umlaufenden Einheit, **dadurch gekennzeichnet, daß** sie eine elektrische Synchronmaschine umfaßt, die mit einer Steuerungsvorrichtung nach Anspruch 10 ausgestattet ist.

12. Antriebsvorrichtung nach Anspruch 11, **dadurch gekennzeichnet, daß** der Rotor (10b) der Synchronmaschine eine massive Welle (110) aus Magnetstahl aufweist, auf deren Oberfläche Permanentmagneten (111, 112) aufgeklebt sind, die außerdem durch wenigstens einen Ring (115) aus Kohlenstoffasern oder Glasfasern gehalten sind.

13. Antriebsvorrichtung nach Anspruch 11 oder Anspruch 12, **dadurch gekennzeichnet, daß** sie einen Synchronmotor zum Antreiben einer Turbomolekularpumpe, einer Turbomaschine oder einer Werkzeughalterspindel umfaßt, die mit Geschwindigkeiten in der Größenordnung von mehreren Zehntausend Umdrehungen pro Minute umlaufen.

FIG.1

EP 1 783 889 B1

FIG.2

FIG.3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9811662 A

**Littérature non-brevet citée dans la description**

- **Ching-Ying Lee et al.** Effects of nonsinusoidal voltage on the operation performance of a three-phase induction motor. IEEE, 02 Juin 1999